(19) Europäisches Patentamt
European Patent Office
Office européen des brevets

(11) **EP 4 102 246 B1**

(12) **FASCICULE DE BREVET EUROPEEN**

(45) Date de publication et mention
de la délivrance du brevet:
**12.07.2023   Bulletin 2023/28**

(21) Numéro de dépôt: **22177316.1**

(22) Date de dépôt: **03.06.2022**

(51) Classification Internationale des Brevets (IPC):
**G01R 35/00** *(2006.01)*     **G01R 15/18** *(2006.01)*

(52) Classification Coopérative des Brevets (CPC):
**G01R 35/005;** G01R 15/181

(54) **CALIBRATION D'UN CAPTEUR DE ROGOWSKI**

EICHUNG VON EINEM ROGOWSKI-SENSOR

CALIBRATION OF A ROGOWSKI SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:   **07.06.2021   FR 2105993**

(43) Date de publication de la demande:
**14.12.2022   Bulletin 2022/50**

(73) Titulaire: **Sagemcom Energy & Telecom SAS**
**92500 Rueil-Malmaison (FR)**

(72) Inventeurs:
• **TEBOULLE, Henri**
**92500 RUEIL MALMAISON (FR)**
• **JEANROT, Marc**
**92500 RUEIL MALMAISON (FR)**
• **SOTIERE, Julien**
**92500 RUEIL MALMAISON (FR)**

(74) Mandataire: **Lavaud, Thomas**
**Cabinet Boettcher**
**5, rue de Vienne**
**75008 Paris (FR)**

(56) Documents cités:
**US-A1- 2008 211 484     US-A1- 2014 340 072
US-A1- 2020 033 435**

**Description**

L'invention concerne le domaine des compteurs électriques multiphasés reliés à des capteurs de Rogowski.

ARRIERE PLAN DE L'INVENTION

Certains compteurs électriques, et notamment les compteurs utilisés dans les applications industrielles, mesurent des puissances et des énergies électriques qui sont distribuées via des niveaux de courant très élevés (jusqu'à 2000A typiquement). Ces compteurs sont généralement des compteurs triphasés.

Les capteurs de courant utilisés sont alors classiquement des capteurs de Rogowski. Dans ces capteurs, le support de la bobine est non ferromagnétique et procure une très bonne linéarité car il n'y a pas de saturation magnétique. Ces capteurs sont donc de très bons candidats pour les applications à haute tension et à courant élevé.

Les capteurs de Rogowski sont généralement installés à une certaine distance du compteur (parfois plus de dix mètres). Chaque capteur est alors positionné sur une phase du réseau de distribution (c'est-à-dire que la boucle de Rogowski entoure le conducteur formant la phase), et est relié au compteur par un cordon.

La calibration des capteurs peut être réalisée en usine, avant que le compteur ne soit livré au client. Chaque capteur est alors apparié avec une phase distincte du compteur, et les paramètres de calibration sont mémorisés dans le compteur.

Cette calibration en usine permet d'utiliser des capteurs de Rogowski non précalibrés (pas de tolérance garantie) et ne requérant pas une précision spécifique. On obtient ainsi les mêmes performances qu'avec des capteurs de Rogowski plus performants « intrinsèquement ».

Cependant, lorsqu'un capteur de Rogowski doit être remplacé sur site, par exemple suite à une panne, il convient d'obtenir avec le nouveau capteur des précisions de mesure équivalentes à celles des autres capteurs reliés au compteur. Or, le banc de test utilisé en usine n'est pas disponible pour réaliser une nouvelle calibration.

Il a donc été envisagé d'utiliser des capteurs de Rogowski précalibrés.

Certains capteurs de Rogowski de l'art antérieur comprennent ainsi un circuit de traitement mémorisant les paramètres de calibration mesurés en usine. Le circuit de traitement comprend par exemple un microcontrôleur et une mémoire situés dans un boîtier lui-même intégré dans le cordon. Ainsi, lorsque le capteur est positionné sur une phase et relié au compteur, sur site, le compteur lit dans le boîtier les paramètres de calibration du capteur et les utilise pour mesurer le courant circulant sur la phase.

Cependant, de tels capteurs sont très coûteux par rapport aux capteurs de Rogowski non précalibrés. Par ailleurs, cette solution est moins flexible car elle requiert d'utiliser un type de capteur bien particulier. US 2014/340072, US 2020/033435 et US 2008/211484 montrent la calibration des capteurs Rogowski.

OBJET DE L'INVENTION

L'invention a pour objet de calibrer sur site, de manière simple et peu coûteuse, un nouveau capteur de Rogowski destiné à être relié à un compteur électrique multiphasé.

RESUME DE L'INVENTION

En vue de la réalisation de ce but, on propose un procédé de calibration sur site d'un capteur de Rogowski à calibrer qui est destiné, en opération, à être relié à un compteur électrique multiphasé en étant positionné sur une phase à calibrer, le procédé comprenant les premières étapes de :

- faire positionner le capteur de Rogowski à calibrer sur une première phase de référence, sur laquelle un premier capteur de Rogowski de référence déjà calibré est positionné, ou bien faire positionner le premier capteur de Rogowski de référence sur la phase à calibrer ;
- acquérir une première mesure de courant de calibration produite par le capteur de Rogowski à calibrer, une première mesure de courant de référence produite par le premier capteur de Rogowski de référence, et une première mesure de tension de référence sur une première phase de positionnement sur laquelle sont positionnés le capteur de Rogowski à calibrer et le premier capteur de Rogowski de référence suite à l'étape de positionnement ;
- utiliser la première mesure de courant de calibration, la première mesure de courant de référence et la première mesure de tension de référence pour produire des premiers paramètres de calibration du capteur de Rogowski à calibrer.

Le procédé de calibration selon l'invention permet donc de calibrer sur site un nouveau capteur de Rogowski, de manière simple, rapide, peu coûteuse, et ne nécessitant pas d'équipement particulier.

Les paramètres de calibration sont définis sur site, et il n'est donc pas nécessaire que le capteur de Rogowski nouvellement installé intègre au préalable ses propres paramètres de calibration. Il est donc possible d'installer sur site et de relier au compteur un capteur de Rogowski du commerce quelconque et non précalibré.

Le procédé de calibration selon l'invention permet donc de réduire le coût des capteurs de Rogowski utilisés et apporte une flexibilité importante quant au choix desdits capteurs.

On propose de plus un procédé de calibration tel que précédemment décrit, comprenant en outre les étapes de calculer une première puissance active de calibration et une première puissance réactive de calibration à partir de la première mesure de courant de calibration et de la première mesure de tension de référence, ainsi qu'une première puissance active de référence et une première puissance réactive de référence à partir de la première mesure de courant de référence et de la première mesure de tension de référence, et de calculer les premiers paramètres de calibration à partir de la première puissance active de calibration, de la première puissance réactive de calibration, de la première puissance active de référence et de la première puissance réactive de référence.

On propose de plus un procédé de calibration tel que précédemment décrit, comprenant de plus des deuxièmes étapes semblables aux premières étapes mais mises en oeuvre avec, à la place de la première phase de référence et du premier capteur de Rogowski de référence, une deuxième phase de référence et un deuxième capteur de Rogowski de référence déjà calibré, les premières étapes et les deuxièmes étapes permettant de produire des paramètres de calibration consolidés du capteur de Rogowski à calibrer.

On propose de plus un procédé de calibration tel que précédemment décrit, les deuxièmes étapes permettant de produire des deuxièmes paramètres de calibration, le procédé comprenant en outre l'étape de calculer une moyenne arithmétique des premiers paramètres de calibration et des deuxièmes paramètres de calibration pour produire les paramètres de calibration consolidés.

On propose de plus un procédé de calibration tel que précédemment décrit, dans lequel les deuxièmes étapes comprennent l'étape de calculer une deuxième puissance active de référence et une deuxième puissance réactive de référence, le procédé comprenant en outre les étapes de calculer une moyenne arithmétique de la première puissance active de référence et de la deuxième puissance active de référence pour obtenir une puissance active de référence moyennée, et de calculer une moyenne arithmétique de la première puissance réactive de référence et de la deuxième puissance réactive de référence pour obtenir une puissance réactive de référence moyennée, les paramètres de calibration consolidés étant obtenus à partir de la première puissance active de calibration, de la première puissance réactive de calibration, de la puissance active de référence moyennée et de la puissance réactive de référence moyennée.

On propose de plus un procédé de calibration tel que précédemment décrit, dans lequel les premières étapes comprennent l'étape de faire positionner le premier capteur de Rogowski de référence sur la phase à calibrer, dans lequel les deuxièmes étapes comprennent l'étape de faire positionner le deuxième capteur de Rogowski de référence sur la phase à calibrer, et dans lequel l'étape d'acquisition des premières étapes et l'étape d'acquisition des deuxièmes étapes sont réalisées simultanément.

On propose de plus un procédé de calibration tel que précédemment décrit, dans lequel les paramètres de calibration comprennent un gain et un déphasage d'une chaîne de mesure de courant comprenant le capteur de Rogowski à calibrer et un circuit de traitement interne intégré dans le compteur et comprenant un intégrateur.

On propose de plus un compteur électrique multiphasé comprenant une unité de traitement agencée pour mettre en oeuvre le procédé de calibration tel que précédemment décrit.

On propose de plus un compteur électrique multiphasé tel que précédemment décrit, comprenant en outre une interface homme-machine, l'unité de traitement étant agencée pour communiquer avec un opérateur via l'interface homme-machine pour lui faire positionner le capteur de Rogowski à calibrer et/ou le premier capteur de Rogowski de référence et/ou le deuxième capteur de Rogowski de référence de manière à mettre en oeuvre le procédé de calibration, et pour, lorsque le procédé de calibration a été réalisé, repositionner le capteur de Rogowski à calibrer et/ou le premier capteur de Rogowski de référence et/ou le deuxième capteur de Rogowski de référence dans leur position nominale, de manière à remettre le compteur et les capteurs de Rogowski dans une configuration nominale.

On propose de plus un programme d'ordinateur comprenant des instructions qui conduisent l'unité de traitement du compteur électrique multiphasé tel que précédemment décrit à exécuter les étapes du procédé de calibration tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente un compteur électrique triphasé et trois capteurs de Rogowski positionnés chacun sur une phase distincte, dans leur position opérationnelle nominale ;

[Fig. 2] la figure 2 est une figure similaire à la figure 1, le capteur à calibrer étant positionné sur une première phase de référence ;

[Fig. 3] la figure 3 est une figure similaire à la figure 1, le capteur à calibrer étant positionné sur une deuxième phase de référence ;

[Fig. 4] la figure 4 est une figure similaire à la figure 1, un premier capteur de référence étant positionné sur la phase à calibrer ;

[Fig. 5] la figure 5 est une figure similaire à la figure 1, le premier capteur de référence et un deuxième capteur de référence étant positionnés sur la phase à calibrer ;

[Fig. 6] la figure 6 représente des étapes du procédé de calibration selon un premier mode de réalisation de l'invention ;

[Fig. 7] la figure 7 représente des étapes du procédé de calibration selon un deuxième mode de réalisation de l'invention.

DESCRIPTION DETAILLEE DE L'INVENTION

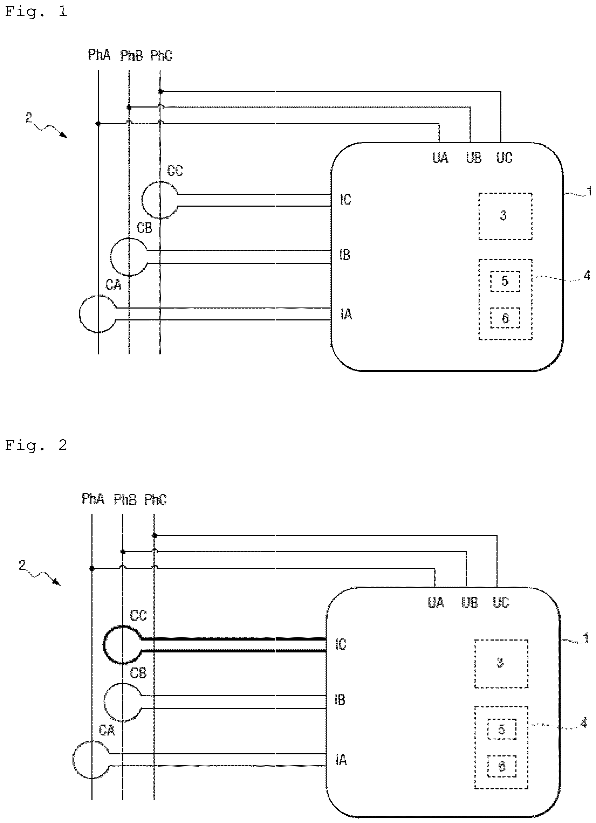

En référence à la figure 1, le procédé de calibration selon un premier mode de réalisation de l'invention est ici mis en oeuvre dans un compteur électrique triphasé 1. Le compteur 1 est utilisé pour mesurer l'énergie électrique fournie à une installation par un réseau de distribution 2 comprenant trois phases : PhA, PhB et PhC.

Le compteur 1 utilise des capteurs de Rogowski CA, CB, CC pour mesurer les courants circulant sur les phases. Les capteurs de Rogowski sont situés à l'extérieur du compteur 1. Chaque capteur de Rogowski est relié au compteur 1 par un cordon possiblement long de plusieurs mètres. Lorsque le compteur 1 est opérationnel et que les capteurs de Rogowski sont installés dans leur position nominale (configuration de la figure 1), le capteur CA est positionné sur la phase PhA en étant relié à une entrée de courant IA du compteur 1, le capteur CB est positionné sur la phase PhB en étant relié à une entrée de courant IB du compteur 1, et le capteur CC est positionné sur la phase PhC en étant relié à une entrée de courant IC du compteur 1. La figure 1 représente donc l'architecture d'interfaçage du compteur 1 au démarrage et en régime permanent.

Pour chaque capteur de Rogowski, le compteur 1 comporte un circuit de traitement interne comprenant un intégrateur ; chaque capteur de Rogowski et le circuit de traitement interne associé forment une « chaîne de mesure de courant ». Bien sûr, certains composants des circuits de traitement internes peuvent être communs aux trois chaînes de mesure de courant.

Le compteur 1 comprend aussi une entrée de tension UA reliée à la phase PhA, une entrée de tension UB reliée à la phase PhB, et une entrée de tension UC reliée à la phase PhC. Le compteur 1 comprend des capteurs de tension reliés aux entrées de tension et permettant de mesurer la tension présente sur chaque phase.

Le compteur 1 comprend aussi une interface homme-machine 3 (IHM) permettant à un opérateur de communiquer avec le compteur 1. L'IHM 3 comporte ici un écran situé sur la face avant du compteur 1, ainsi que des boutons situés eux aussi sur la face avant du compteur 1 et permettant à l'opérateur de naviguer dans des menus affichés sur l'écran, et de rentrer des instructions pour commander certaines fonctions mises en oeuvre par le compteur 1.

Le compteur 1 comprend aussi une unité de traitement 4 comportant au moins un composant de traitement 5 adapté à exécuter des instructions d'un programme pour mettre en oeuvre le procédé de calibration selon l'invention. Le programme est stocké dans une mémoire 6 de l'unité de traitement 4, qui est intégrée dans ou reliée au composant de traitement 5. Le composant de traitement 5 est par exemple un processeur classique, un microcontrôleur, un DSP (pour *Digital Signal Processor,* que l'on peut traduire par «processeur de signal numérique »), ou bien un circuit logique programmable tel qu'un FPGA (pour *Field Programmable Gate Arrays*) ou un ASIC (pour *Application Spécifie Integrated Circuit*).

En référence à la figure 2, on décrit tout d'abord le procédé de calibration selon un premier mode de réalisation de l'invention.

La figure 2 correspond à une situation dans laquelle un nouveau capteur CC doit être installé, par exemple parce que le précédent capteur CC est défectueux. Le compteur 1 ne connaît pas le nouveau capteur CC, qui doit donc être calibré. La calibration est donc réalisée sur site (et non en usine ou en atelier), c'est-à-dire après que le compteur 1 a été livré et installé chez le client. Les autres capteurs CA et CB sont opérationnels et ont déjà été calibrés en usine (tout comme le précédent capteur CC). Le procédé de calibration utilise des mesures de référence réalisées par l'un ou les deux capteurs CA et CB pour calibrer le nouveau capteur CC.

L'opérateur utilise tout d'abord un menu affiché sur l'écran du compteur 1 pour mettre le compteur 1 dans un mode de calibration.

L'opérateur précise alors que le capteur à calibrer est le capteur CC. L'opérateur renseigne ensuite une première phase de référence, qui est ici par exemple la phase PhB. Le capteur CB, déjà calibré, se trouve sur la première phase

EP 4 102 246 B1

de référence et joue le rôle d'un premier capteur de référence.

L'unité de traitement 4 communique alors avec l'opérateur via l'écran, et lui demande de positionner le capteur CC sur la phase PhB.

Suite à cette étape de positionnement, deux capteurs sont positionnés sur la phase PhB : le capteur CB et le capteur CC.

L'unité de traitement 4 du compteur 1 sait alors que le capteur à calibrer est celui connecté à l'entrée de courant IC (capteur CC) et que le premier capteur de référence est celui connecté à l'entrée de courant IB (capteur CB).

L'unité de traitement 4 acquiert alors une première mesure de courant de calibration produite par le capteur CC, une première mesure de courant de référence produite par le capteur CB, et une première mesure de tension de référence. La première mesure de tension de référence est une mesure de tension sur une première phase de positionnement sur laquelle sont positionnés le capteur CC et le capteur CB suite à l'étape de positionnement. La première phase de positionnement est donc la phase PhB. La première mesure de tension de référence est produite par le capteur de tension relié à l'entrée de tension UB.

L'unité de traitement 4 utilise alors la première mesure de courant de calibration, la première mesure de courant de référence et la première mesure de tension de référence pour produire des premiers paramètres de calibration du capteur de Rogowski à calibrer (le capteur CC).

Plus précisément, l'unité de traitement 4 calcule une première puissance active de calibration Pm et une première puissance réactive de calibration Qm à partir de la première mesure de courant de calibration et de la première mesure de tension de référence, ainsi qu'une première puissance active de référence Pref et une première puissance réactive de référence Qref à partir de la première mesure de courant de référence et de la première mesure de tension de référence, et calcule les premiers paramètres de calibration à partir de la première puissance active de calibration, de la première puissance réactive de calibration, de la première puissance active de référence et de la première puissance réactive de référence.

Les premiers paramètres de calibration du capteur CC comprennent un gain $K_1$ et un déphasage $\Delta\varphi_1$ de la totalité de la chaîne de mesure de courant du capteur CC, incluant le gain et le déphasage du capteur CC et de l'intégrateur interne dans le compteur 1.

Pour déterminer les paramètres de calibration $K_1$ et $\Delta\varphi_1$, l'unité de traitement 4 résout le système suivant de deux équations à deux inconnues ($K_1$ et $\Delta\varphi_1$) :

$$P_{ref} = K_1.\cos(\Delta\varphi_1).Pm + K_1.\sin(\Delta\varphi_1).Qm$$

$$Q_{ref} = -K_1.\sin(\Delta\varphi_1).Pm + K_1.\cos(\Delta\varphi_1).Qm$$

Une valeur typique de $K_1$ est par exemple 5/10000 (courant de 2000A ramené à IV par exemple). Une valeur typique de $\Delta\varphi_1$ est par exemple 0,05°.

On note que, par « mesure » (de courant, de tension), on n'entend pas nécessairement une unique mesure mais plutôt plusieurs mesures réalisées sur une certaine durée (une minute par exemple) et traitées (moyennées ou filtrées par exemple) pour obtenir une mesure consolidée.

Les premiers paramètres de calibration sont alors enregistrés et utilisés par l'unité de traitement 4 pour calibrer le capteur CC.

L'unité de traitement 4 demande alors à l'opérateur, via l'IHM 3, de repositionner correctement les capteurs dans leur position nominale, de manière à remettre le compteur 1 et les capteurs dans une configuration nominale. Ici, en l'occurrence, l'unité de traitement 4 fait repositionner le capteur CC sur la phase PhC (les capteurs CA et CB n'ayant pas été déplacés).

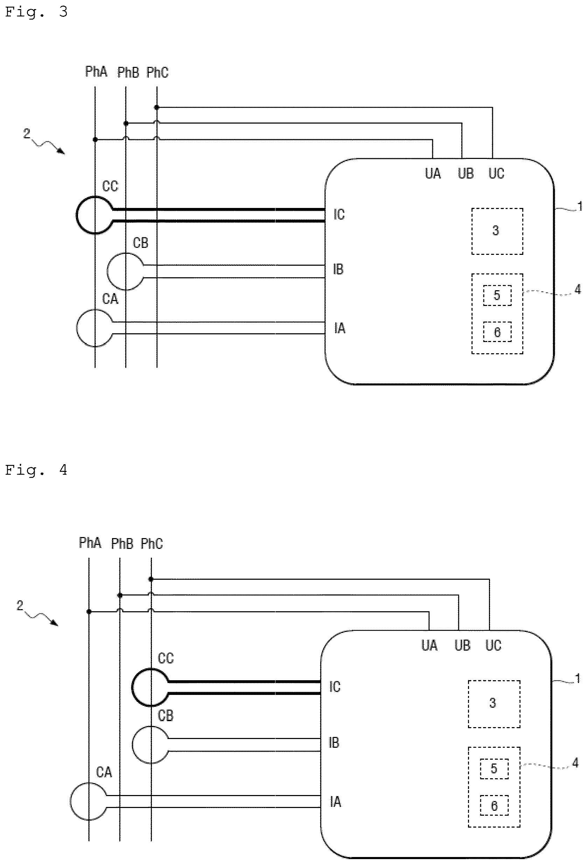

En référence à la figure 3, il est possible de répéter les premières étapes de calibration qui viennent d'être décrites. On réalise ainsi des deuxièmes étapes de calibration semblables aux premières étapes de calibration, mais mises en oeuvre avec, à la place de la première phase de référence (PhB) et du premier capteur de Rogowski de référence (CB), une deuxième phase de référence (PhA) et un deuxième capteur de Rogowski de référence (CA) déjà calibré et destiné, en opération, à être relié au compteur 1 en étant positionné sur la deuxième phase de référence (PhA). Les premières étapes et les deuxièmes étapes permettent de produire des paramètres de calibration consolidés (plus précis) du capteur de Rogowski à calibrer CC.

On réalise ainsi non pas une mais deux calibrations en positionnant tout d'abord le capteur CC sur la phase PhB (figure 2), puis en positionnant le capteur CC sur la phase PhA (figure 3). Les premières étapes de calibration permettent d'obtenir des premiers paramètres de calibration, $K_1$ et $\Delta\varphi_1$, alors que les deuxièmes étapes de calibration permettent d'obtenir des deuxièmes paramètres de calibration $K_2$ et $\Delta\varphi_2$.

Les deuxièmes paramètres de calibration sont obtenus en calculant une deuxième puissance active de calibration et une deuxième puissance réactive de calibration, ainsi qu'une deuxième puissance active de référence et une deuxième puissance réactive de référence.

La deuxième puissance active de calibration et la deuxième puissance réactive de calibration sont calculées à partir de la deuxième mesure de courant de calibration (produite par le capteur CC) et de la deuxième mesure de tension de référence (sur la phase PhA). La deuxième puissance active de référence et la deuxième puissance réactive de référence sont calculées à partir de la deuxième mesure de courant de référence (produite par le capteur CA) et de la deuxième mesure de tension de référence (sur la phase PhA).

L'unité de traitement 4 produit alors des paramètres de calibration consolidés.

L'unité de traitement 4 calcule par exemple une moyenne arithmétique des premiers paramètres de calibration et des deuxièmes paramètres de calibration (c'est-à-dire, d'une part, une moyenne de $K_1$ et de $K_2$ et, d'autre part, une moyenne de $\Delta\varphi_1$ et de $\Delta\varphi_2$) pour produire les paramètres de calibration consolidés.

On décrit maintenant, en référence à la figure 4, le procédé de calibration selon un deuxième mode de réalisation de l'invention.

Le capteur à calibrer est à nouveau le capteur CC. L'opérateur désigne cette fois tout d'abord non pas une première phase de référence mais un premier capteur de référence, ici le capteur CB.

L'unité de traitement 4 demande alors à l'opérateur de positionner le capteur CB sur la phase à calibrer, qui est ici la phase PhC. La phase à calibrer est la phase sur laquelle le capteur à calibrer est destiné à être positionné en opération.

Deux capteurs sont alors positionnés sur la phase PhC : le capteur à calibrer CC et le premier capteur de référence CB.

L'unité de traitement 4 du compteur 1 sait que le capteur de Rogowski à calibrer est celui connecté à l'entrée de courant IC (capteur CC) et que le premier capteur de référence est celui connecté à l'entrée de courant IB (capteur CB).

L'unité de traitement 4 acquiert alors une première mesure de courant de calibration produite par le capteur CC, une première mesure de courant de référence produite par le capteur CB, et une première mesure de tension de référence sur la phase PhC (sur laquelle sont positionnés le capteur à calibrer CC et le premier capteur de référence suite à l'étape de positionnement).

La première mesure de tension de référence est produite par le capteur de tension relié à l'entrée de tension UC.

L'unité de traitement 4 utilise alors la première mesure de courant de calibration, la première mesure de courant de référence et la première mesure de tension de référence pour produire des premiers paramètres de calibration du capteur CC.

Plus précisément, l'unité de traitement 4 calcule une première puissance active de calibration Pm et une première puissance réactive de calibration Qm à partir de la première mesure de courant de calibration et de la première mesure de tension de référence, ainsi qu'une première puissance active de référence Pref et une première puissance réactive de référence Qref à partir de la première mesure de courant de référence et de la première mesure de tension de référence. L'unité de traitement 4 calcule les premiers paramètres de calibration à partir de la première puissance active de calibration, de la première puissance réactive de calibration, de la première puissance active de référence et de la première puissance réactive de référence.

Les premiers paramètres de calibration comprennent un gain $K_1$ et un déphasage $\Delta\varphi_1$ de la chaîne de mesure de courant du capteur CC.

Pour déterminer les paramètres de calibration $K_1$ et $\Delta\varphi_1$, l'unité de traitement 4 résout le système suivant de deux équations à deux inconnues ($K_1$ et $\Delta\varphi_1$) :

$$P_{ref} = K_1.\cos(\Delta\varphi_1).Pm + K_1.\sin(\Delta\varphi_1).Qm$$

$$Q_{ref} = -K_1.\sin(\Delta\varphi_1).Pm + K_1.\cos(\Delta\varphi_1).Qm$$

L'unité de traitement 4 demande alors à l'opérateur, via l'IHM 3, de repositionner correctement les capteurs dans leur position nominale, de manière à rendre le compteur 1 opérationnel. Ici, en l'occurrence, l'unité de traitement 4 fait repositionner le capteur CB sur la phase PhB (les capteurs CA et CC n'ayant pas été déplacés).

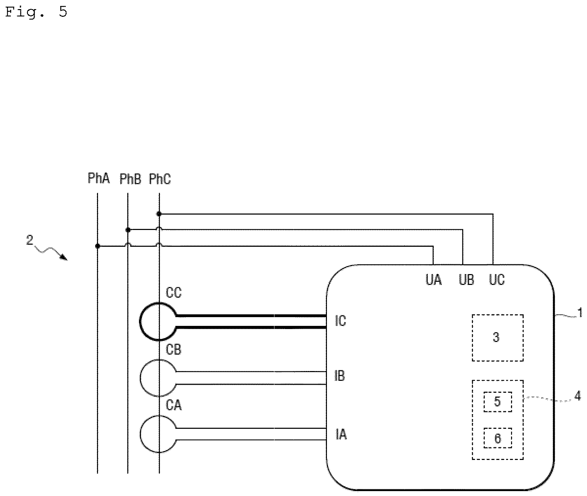

En référence à la figure 5, il est possible de répéter les premières étapes de calibration qui viennent d'être décrites. On réalise ainsi des deuxièmes étapes de calibration semblables aux premières étapes de calibration, mais mises en oeuvre avec, à la place du premier capteur de Rogowski de référence (CB), un deuxième capteur de Rogowski de référence (CA).

On réalise ainsi non pas une mais deux calibrations simultanées en positionnant tout d'abord le capteur CB sur la phase à calibrer CC, puis en positionnant le capteur CA sur la phase à calibrer CC.

Les premières étapes de calibration et les deuxièmes étapes de calibration, réalisées simultanément, permettent de produire des paramètres de calibration consolidés du capteur de Rogowski à calibrer CC.

Les premières étapes de calibration permettent de calculer une première puissance active de calibration $P_m$ et une première puissance réactive de calibration $Q_m$, ainsi qu'une première puissance active de référence $P_{ref1}$ et une première puissance réactive de référence $Q_{ref1}$. Les deuxièmes étapes de calibration permettent calculer simultanément une deuxième puissance active de référence $P_{ref2}$ et une deuxième puissance réactive de référence $Q_{ref2}$.

L'unité de traitement 4 calcule alors une moyenne arithmétique de la première puissance active de référence $P_{ref1}$ et de la deuxième puissance active de référence $P_{ref2}$ pour obtenir une puissance active de référence moyennée $P_{ref}$, et calcule une moyenne arithmétique de la première puissance réactive de référence $Q_{ref1}$ et de la deuxième puissance réactive de référence $Q_{ref2}$ pour obtenir une puissance réactive de référence moyennée $Q_{ref}$.

Les paramètres de calibration consolidés sont obtenus à partir de la première puissance active de calibration $P_m$, de la première puissance réactive de calibration $Q_m$, de la puissance active de référence moyennée $P_{ref}$ et de la puissance réactive de référence moyennée $Q_{ref}$.

L'unité de traitement 4 résout ainsi un système de deux équations à deux inconnues ($K_1$ et $\Delta\varphi_1$).

$$P_{ref} = K_1.\cos(\Delta\varphi_1).Pm + K_1.\sin(\Delta\varphi_1).Qm$$

$$Q_{ref} = -K_1.\sin(\Delta\varphi_1).Pm + K_1.\cos(\Delta\varphi_1).Qm$$

avec $P_{ref} = \dfrac{(P_{ref1}+P_{ref2})}{2}$ et $Q_{ref} = \dfrac{(Q_{ref1}+Q_{ref2})}{2}$ .

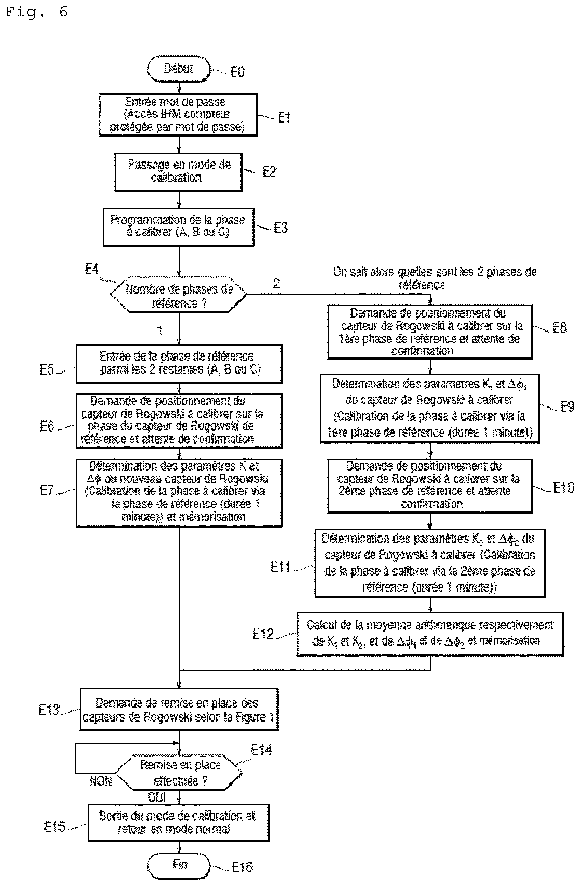

On décrit maintenant, en référence à la figure 6, un organigramme du procédé de calibration selon le premier mode de réalisation de l'invention. C'est donc le capteur de Rogowski à calibrer (capteur CC) qui est positionné sur la phase de référence qui a été choisie ou bien, si deux phases de référence sont choisies, qui est positionné successivement sur chacune des phases de référence.

Le procédé débute à l'étape E0.

Pour démarrer le procédé de calibration, l'opérateur doit préalablement entrer un mot de passe de protection d'accès à l'IHM 3 du compteur 1 (étape E1), puis demander à entrer effectivement en mode de calibration (étape E2).

L'opérateur programme alors la phase à calibrer - qui est la phase PhC (étape E3).

Puis, l'unité de traitement 4 demande à l'opérateur, via l'IHM 3, de renseigner le nombre de phases de référence (étape E4).

Suite à l'étape E4, dans le cas où il n'y a qu'une phase de référence, l'unité de traitement 4 demande à l'opérateur, via l'IHM 3, de renseigner la phase de référence (étape E5), puis de positionner le capteur de Rogowski à calibrer (capteur CC) sur la phase de référence (ici par exemple sur la phase PhB) : étape E6.

L'unité de traitement 4 attend alors une confirmation de l'opérateur que le positionnement a bien été effectué. Cette confirmation est réalisée par l'opérateur via l'IHM 3. Le compteur 1 passe en mode effectif de calibration.

L'unité de traitement 4 acquiert la mesure de courant de calibration (capteur CC), la mesure de courant de référence (capteur CB) et la mesure de tension de référence (phase CB), et détermine les paramètres de calibration K et $\Delta\varphi$ (étape E7). Les mesures sont réalisées sur une durée d'une minute par exemple.

Les paramètres de calibration K et $\Delta\varphi$ sont alors mémorisés dans le compteur 1 en tant que paramètres de calibration du nouveau capteur de Rogowski, c'est-à-dire du capteur CC.

Suite à l'étape E4, dans le cas où il y a deux phases de référence (la phase PhB et la phase PhA), l'unité de traitement 4 demande tout d'abord à l'opérateur, via l'IHM 3, de positionner le capteur CC sur la phase PhB (première phase de référence) : étape E8.

L'unité de traitement 4 attend la confirmation que ce positionnement a bien été effectué.

L'unité de traitement 4 acquiert la première mesure de courant de calibration (capteur CC), la première mesure de courant de référence (capteur CB) et la première mesure de tension de référence (phase CB), et détermine les premiers paramètres de calibration $K_1$ et $\Delta\varphi_1$ (étape E9). Les mesures sont réalisées sur une durée d'une minute par exemple.

Puis, l'unité de traitement 4 demande à l'opérateur, via l'IHM 3, de positionner le capteur CC sur la phase PhA (deuxième phase de référence) : étape E10.

L'unité de traitement 4 attend la confirmation que ce positionnement a bien été effectué.

L'unité de traitement 4 acquiert la deuxième mesure de courant de calibration (capteur CC), la deuxième mesure de courant de référence (capteur CA) et la deuxième mesure de tension de référence (phase CA), et détermine les deuxièmes paramètres de calibration $K_2$ et $\Delta\varphi_2$ (étape E11). Les mesures sont réalisées sur une durée d'une minute par exemple.

Enfin, l'unité de traitement 4 calcule la moyenne arithmétique d'une part de $K_1$ et de $K_2$, et d'autre part de $\Delta\varphi_1$ et de $\Delta\varphi_2$, et produit ainsi les paramètres de calibration consolidés. Les paramètres de calibration consolidés sont mémorisés et utilisés en tant que paramètres de calibration du nouveau capteur de Rogowski (capteur CC) : étape E12.

Suite à l'étape E7 ou à l'étape E12, l'unité de traitement 4 demande à l'opérateur, via l'IHM 3, de remettre en place les capteurs de Rogowski conformément à la configuration de la Figure 1 (étape E13).

Lorsque l'unité de traitement 4 reçoit la confirmation que ce positionnement a bien été effectué (étape E14), le compteur 1 sort du mode de calibration et retourne dans le mode normal (étape E1\5). Le procédé de calibration s'achève (étape E16).

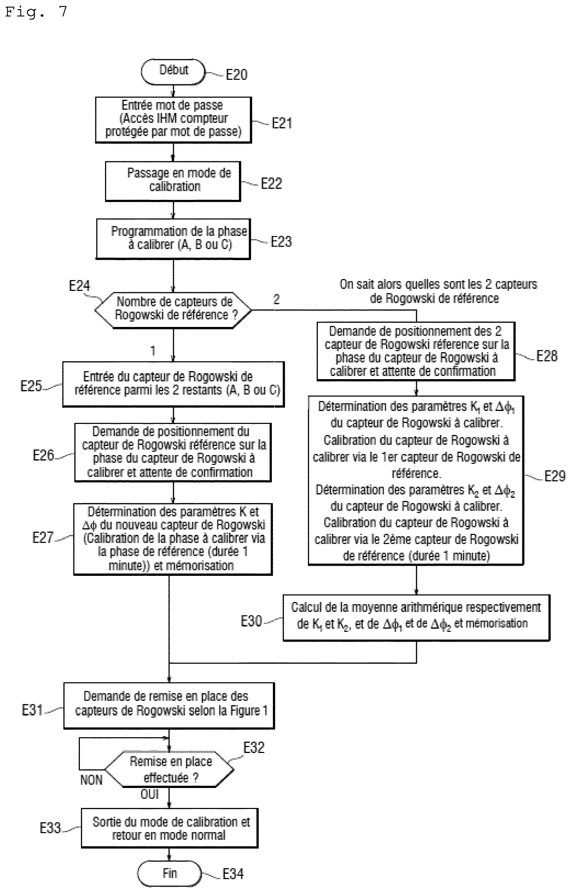

On décrit maintenant, en référence à la figure 7, un organigramme du procédé de calibration selon le deuxième mode de réalisation de l'invention.

Cette fois, c'est le premier capteur de référence (ici le capteur CB) qui est amené sur la phase à calibrer PhC du capteur de Rogowski à calibrer (capteur CC), ou bien ce sont les capteurs de référence (capteur CB et capteur CA) qui sont amenés sur la phase CC.

Le procédé débute à l'étape E20.

Pour démarrer le procédé de calibration, l'opérateur doit préalablement entrer un mot de passe de protection d'accès de l'IHM 3 du compteur 1 (étape E21), puis demander à entrer effectivement en mode de calibration (étape E22).

L'opérateur programme alors la phase à calibrer - qui est la phase PhC (étape E23).

Puis, l'unité de traitement 4 demande à l'opérateur, via l'IHM 3, de renseigner le nombre de capteurs de référence (étape E24).

Suite à l'étape E24, dans le cas où il n'y a qu'un capteur de référence, l'unité de traitement 4 demande à l'opérateur, via l'écran de l'IHM 3, d'indiquer le capteur de référence (étape E25), puis de positionner le capteur de référence (capteur CB) sur la phase à calibrer (phase PhC) : étape E26.

L'unité de traitement 4 attend alors une confirmation de l'opérateur que le positionnement a bien été effectué. Cette confirmation est réalisée par l'opérateur via l'IHM 3.

L'unité de traitement 4 acquiert la mesure de courant de calibration (capteur CC), la mesure de courant de référence (capteur CB) et la mesure de tension de référence (phase CC), et détermine les paramètres de calibration K et $\Delta\varphi$ (étape E27). Les mesures sont réalisées sur une durée d'une minute par exemple.

Les paramètres de calibration K et $\Delta\varphi$ sont alors mémorisés dans le compteur 1 en tant que paramètres de calibration du nouveau capteur de Rogowski, c'est-à-dire du capteur CC.

Suite à l'étape E24, dans le cas où il y a deux capteurs de référence (le capteur CB et le capteur CA), l'unité de traitement 4 demande à l'opérateur, via l'IHM 3, de positionner le premier capteur de référence CB sur la phase PhC et le deuxième capteur de référence CA sur la phase PhC (étape E28).

L'unité de traitement 4 attend la confirmation que ce positionnement a bien été effectué.

L'unité de traitement 4 acquiert la première mesure de courant de calibration (capteur CC), la première mesure de courant de référence (capteur CB) et la première mesure de tension de référence (phase CC), et détermine les premiers paramètres de calibration $K_1$ et $\Delta\varphi_1$.

L'unité de traitement 4 acquiert simultanément la deuxième mesure de courant de référence (capteur CA) et détermine les deuxièmes paramètres de calibration $K_2$ et $\Delta\varphi_2$ (étape E29). L'unité de traitement 4 utilise donc, pour déterminer les deuxièmes paramètres de calibration $K_2$ et $\Delta\varphi_2$, la première mesure de courant de calibration et la première mesure de tension de référence.

Les mesures de l'étape E29 sont ici réalisées simultanément sur une durée d'une minute par exemple.

Enfin, l'unité de traitement 4 calcule la moyenne arithmétique d'une part de $K_1$ et de $K_2$, et d'autre part de $\Delta\varphi_1$ et de $\Delta\varphi_2$, et produit ainsi les paramètres de calibration consolidés. Les paramètres de calibration consolidés sont mémorisés et utilisés en tant que paramètres de calibration du nouveau capteur de Rogowski (capteur CC) : étape E30.

Suite à l'étape E27 ou à l'étape E30, l'unité de traitement 4 demande à l'opérateur, via l'IHM 3, de remettre en place les capteurs de Rogowski conformément à la configuration de la Figure 1 : étape E31.

Lorsque l'unité de traitement 4 reçoit la confirmation que ce positionnement a bien été effectué (étape E32), le compteur 1 sort du mode de calibration et retourne dans le mode normal (étape E33). Le procédé de calibration s'achève (étape E34).

On note qu'au cours de l'étape E30, les paramètres de calibration consolidés pourraient être obtenus non pas à partir des $K_1$, $K_2$, $\Delta\varphi_1$ et $\Delta\varphi_2$, mais à partir de la puissance active de référence moyennée (obtenue elle-même à partir de $P_{ref1}$ et de $P_{ref2}$) et de la puissance réactive de référence moyennée (obtenue elle-même à partir de $Q_{ref1}$ et de $Q_{ref2}$).

Bien entendu, l'invention n'est pas limitée aux modes de réalisation décrits mais englobe toute variante entrant dans le champ de l'invention telle que définie par les revendications.

L'invention peut être mise en œuvre avec un compteur électrique multiphasé relié à un nombre de phases quelconque (supérieur ou égal à deux).

L'architecture des figures 1 à 5 pourrait comprendre un fil de neutre venant du réseau et entrant dans le compteur, en plus des trois entrées de tension réseau UA, UB et UC (on parle alors de « mode quatre fils »).

L'invention peut s'appliquer pour un compteur conforme ou non à la directive MID.

On note que, pendant la mise en oeuvre du procédé de calibration, il est possible détecter si les capteurs de Rogowski sont correctement installés (à partir du sens du courant), et de générer une alarme lorsqu'un capteur Rogowski est installé à l'envers.

**Revendications**

1. Procédé de calibration sur site d'un capteur de Rogowski à calibrer (CC) qui est destiné, en opération, à être relié à un compteur électrique multiphasé (1) en étant positionné sur une phase à calibrer (PhC), où le procédé est **caractérisé par** les premières étapes de :

   - faire positionner le capteur de Rogowski à calibrer sur une première phase de référence (PhB), sur laquelle un premier capteur de Rogowski de référence (CB) déjà calibré est positionné, ou bien faire positionner le premier capteur de Rogowski de référence sur la phase à calibrer ;
   - acquérir une première mesure de courant de calibration produite par le capteur de Rogowski à calibrer (CC), une première mesure de courant de référence produite par le premier capteur de Rogowski de référence (CB), et une première mesure de tension de référence sur une première phase de positionnement (PhB ; PhC) sur laquelle sont positionnés le capteur de Rogowski à calibrer et le premier capteur de Rogowski de référence suite à l'étape de positionnement ;
   - utiliser la première mesure de courant de calibration, la première mesure de courant de référence et la première mesure de tension de référence pour produire des premiers paramètres de calibration ($K_1$, $\Delta\varphi_1$) du capteur de Rogowski à calibrer.

2. Procédé de calibration selon la revendication 1, comprenant en outre les étapes de calculer une première puissance active de calibration et une première puissance réactive de calibration à partir de la première mesure de courant de calibration et de la première mesure de tension de référence, ainsi qu'une première puissance active de référence et une première puissance réactive de référence à partir de la première mesure de courant de référence et de la première mesure de tension de référence, et de calculer les premiers paramètres de calibration à partir de la première puissance active de calibration, de la première puissance réactive de calibration, de la première puissance active de référence et de la première puissance réactive de référence.

3. Procédé de calibration selon l'une des revendications précédentes, comprenant de plus des deuxièmes étapes semblables aux premières étapes mais mises en oeuvre avec, à la place de la première phase de référence et du premier capteur de Rogowski de référence, une deuxième phase de référence (PhA) et un deuxième capteur de Rogowski de référence (CA) déjà calibré, les premières étapes et les deuxièmes étapes permettant de produire des paramètres de calibration consolidés du capteur de Rogowski à calibrer (CC) .

4. Procédé de calibration selon la revendication 3, les deuxièmes étapes permettant de produire des deuxièmes paramètres de calibration ($K_2$, $\Delta\varphi_2$), le procédé comprenant en outre l'étape de calculer une moyenne arithmétique des premiers paramètres de calibration et des deuxièmes paramètres de calibration pour produire les paramètres de calibration consolidés.

5. Procédé de calibration selon la revendication 2 et la revendication 3, dans lequel les deuxièmes étapes comprennent l'étape de calculer une deuxième puissance active de référence et une deuxième puissance réactive de référence, le procédé comprenant en outre les étapes de calculer une moyenne arithmétique de la première puissance active de référence et de la deuxième puissance active de référence pour obtenir une puissance active de référence moyennée, et de calculer une moyenne arithmétique de la première puissance réactive de référence et de la deuxième puissance réactive de référence pour obtenir une puissance réactive de référence moyennée, les paramètres de calibration consolidés étant obtenus à partir de la première puissance active de calibration, de la première puissance réactive de calibration, de la puissance active de référence moyennée et de la puissance réactive de référence moyennée.

6. Procédé de calibration selon les revendications 2 et 3, dans lequel les premières étapes comprennent l'étape de faire positionner le premier capteur de Rogowski de référence (CB) sur la phase à calibrer (PhC), dans lequel les deuxièmes étapes comprennent l'étape de faire positionner le deuxième capteur de Rogowski de référence (CA) sur la phase à calibrer (PhC), et dans lequel l'étape d'acquisition des premières étapes et l'étape d'acquisition des deuxièmes étapes sont réalisées simultanément.

7. Procédé de calibration selon l'une des revendications précédentes, dans lequel les paramètres de calibration comprennent un gain et un déphasage d'une chaîne de mesure de courant comprenant le capteur de Rogowski à calibrer (CC) et un circuit de traitement interne intégré dans le compteur et comprenant un intégrateur.

8. Compteur électrique multiphasé comprenant une unité de traitement (4) agencée pour mettre en oeuvre le procédé de calibration selon l'une des revendications précédentes.

9. Compteur électrique multiphasé selon la revendication 8, comprenant en outre une interface homme-machine (3), l'unité de traitement (4) étant agencée pour communiquer avec un opérateur via l'interface homme-machine (3) pour lui faire positionner le capteur de Rogowski à calibrer (CC) et/ou le premier capteur de Rogowski de référence (CB) et/ou le deuxième capteur de Rogowski de référence (CA) de manière à mettre en oeuvre le procédé de calibration, et pour, lorsque le procédé de calibration a été réalisé, repositionner le capteur de Rogowski à calibrer et/ou le premier capteur de Rogowski de référence et/ou le deuxième capteur de Rogowski de référence dans leur position nominale, de manière à remettre le compteur et les capteurs de Rogowski dans une configuration nominale.

10. Programme d'ordinateur comprenant des instructions qui conduisent l'unité de traitement (4) du compteur électrique multiphasé (1) selon l'une des revendications 8 ou 9 à exécuter les étapes du procédé de calibration selon l'une des revendications 1 à 7.

11. Support d'enregistrement lisible par ordinateur, sur lequel est enregistré le programme d'ordinateur selon la revendication 10.

**Patentansprüche**

1. Verfahren zur Vor-Ort-Kalibrierung eines zu kalibrierenden Rogowski-Sensors (CC), der dazu bestimmt ist, im Gebrauch mit einem mehrphasigen Stromzähler (1) verbunden zu werden, indem er auf einer zu kalibrierenden Phase (PhC) positioniert wird, wobei das Verfahren durch die ersten Schritte gekennzeichnet ist:

   - Positionieren des zu kalibrierenden Rogowski-Sensors auf einer ersten Referenz-Phase (PhB), auf der ein erster bereits kalibrierter Referenz-Rogowski-Sensor (CB) positioniert ist, oder Positionieren des ersten Referenz-Rogowski-Sensors auf der zu kalibrierenden Phase;
   - Erfassen einer ersten Kalibrierungsstrommessung, die von dem zu kalibrierenden Rogowski-Sensor (CC) erzeugt wird, einer ersten Referenz-Strommessung, die von dem ersten Referenz-Rogowski-Sensor (CB) erzeugt wird, und einer ersten Referenz-Spannungsmessung auf einer ersten Positionierungsphase (PhB; PhC), auf der der zu kalibrierende Rogowski-Sensor und der erste Referenz-Rogowski-Sensor positioniert sind, nach dem Positionierungsschritt;
   - Verwenden der ersten Kalibrierungsstrommessung, der ersten Referenz-Strommessung und der ersten Referenz-Spannungsmessung, um erste Kalibrierungsparameter ($K_1$, $\Delta\phi_1$) des zu kalibrierenden Rogowski-Sensors zu erzeugen.

2. Kalibrierungsverfahren nach Anspruch 1, ferner umfassend die Schritte des Berechnens einer ersten Kalibrierungswirkleistung und einer ersten Kalibrierungsblindleistung anhand der ersten Kalibrierungsstrommessung und der ersten Referenz-Spannungsmessung, sowie einer ersten Referenz-Wirkleistung und einer ersten Referenz-Blindleistung anhand der ersten Referenz-Strommessung und der ersten Referenz-Spannungsmessung, und Berechnen der ersten Kalibrierungsparameter anhand der ersten Kalibrierungswirkleistung, der ersten Kalibrierungsblindleistung, der ersten Referenz-Wirkleistung und der ersten Referenz-Blindleistung.

3. Kalibrierungsverfahren nach einem der vorhergehenden Ansprüche, ferner umfassend zweite Schritte, die ähnlich zu den ersten Schritten sind, jedoch anstelle der ersten Referenz-Phase und des ersten Referenz-Rogowski-Sensors, mit einer zweiten Referenz-Phase (PhA) und einem zweiten bereits kalibrierten Referenz-Rogowski-Sensor (CA) implementiert werden, wobei die ersten Schritte und die zweiten Schritte das Erzeugen von konsolidierten Kalibrierungsparametern des zu kalibrierenden Rogowski-Sensors (CC) ermöglichen.

4. Kalibrierungsverfahren nach Anspruch 3, wobei die zweiten Schritte das Erzeugen von zweiten Kalibrierungsparametern ($K_2$, $\Delta\phi_2$) ermöglichen, wobei das Verfahren ferner den Schritt des Berechnens eines arithmetischen Mittels der ersten Kalibrierungsparameter und der zweiten Kalibrierungsparameter umfasst, um die konsolidierten Kalibrierungsparameter zu erzeugen.

5. Kalibrierungsverfahren nach Anspruch 2 oder Anspruch 3, bei dem die zweiten Schritte den Schritt des Berechnens einer zweiten Referenz-Wirkleistung und einer zweiten Referenz-Blindleistung umfassen, wobei das Verfahren ferner die Schritte des Berechnens eines arithmetischen Mittels der ersten Referenz-Wirkleistung und der zweiten Referenz-Wirkleistung umfasst, um eine gemittelte Referenz-Wirkleistung zu erhalten, und des Berechnens eines arithmetischen Mittels der ersten Referenz-Blindleistung und der zweiten Referenz-Blindleistung, um eine gemittelte Referenz-Blindleistung zu erhalten, wobei die konsolidierten Kalibrierungsparameter anhand der ersten Kalibrierungswirkleistung, der ersten Kalibrierungsblindleistung, der gemittelten Referenz-Wirkleistung und der gemittelten Referenz-Blindleistung erhalten werden.

6. Kalibrierungsverfahren nach den Ansprüchen 2 und 3, bei dem die ersten Schritte den Schritt des Positionierens des ersten Referenz-Rogowski-Sensors (CB) auf der zu kalibrierenden Phase (PhC) umfassen, bei dem die zweiten Schritte den Schritt des Positionierens des zweiten Referenz-Rogowski-Sensors (CA) auf der zu kalibrierenden Phase (PhC) umfassen, und bei dem der Erfassungsschritt der ersten Schritte und der Erfassungsschritt der zweiten Schritte gleichzeitig erfolgen.

7. Kalibrierungsverfahren nach einem der vorhergehenden Ansprüche, bei dem die Kalibrierungsparameter eine Verstärkung und eine Phasenverschiebung einer Strommesskette umfassen, die den zu kalibrierenden Rogowski-Sensor (CC) und eine interne Verarbeitungsschaltung umfasst, die in den Zähler integriert ist und einen Integrator umfasst.

8. Mehrphasiger Stromzähler, umfassend eine Verarbeitungseinheit (4), die ausgebildet ist, das Kalibrierungsverfahren nach einem der vorhergehenden Ansprüche durchzuführen.

9. Mehrphasiger Stromzähler nach Anspruch 8, ferner umfassend eine Mensch-Maschine-Schnittstelle (3), wobei die Verarbeitungseinheit (4) ausgebildet ist, über die Mensch-Maschine-Schnittstelle (3) mit einem Bediener zu kommunizieren, damit er den zu kalibrierenden Rogowski-Sensor (CC) und/oder den ersten Referenz-Rogowski-Sensor (CB) und/oder den zweiten Referenz-Rogowski-Sensor (CA) derart positioniert, dass das Kalibrierungsverfahren umgesetzt wird, und um, wenn das Kalibrierungsverfahren durchgeführt wurde, den zu kalibrierenden Rogowski-Sensor und/oder den ersten Referenz-Rogowski-Sensor und/oder den zweiten Referenz-Rogowski-Sensor wieder in ihrer nominalen Position zu positionieren, um den Zähler und die Rogowski-Sensoren in eine nominale Konfiguration zurückzusetzen.

10. Computerprogramm, umfassend Anweisungen, die die Verarbeitungseinheit (4) des mehrphasigen Stromzählers (1) nach einem der Ansprüche 8 oder 9 dazu veranlassen, die Schritte des Kalibrierungsverfahrens nach einem der Ansprüche 1 bis 7 auszuführen.

11. Computerlesbarer Aufzeichnungsträger, auf dem das Computerprogramm nach Anspruch 10 gespeichert ist.

**Claims**

1. Method for the onsite calibration of a Rogowski sensor to be calibrated (CC) which is intended, in operation, to be connected to a multiphase electricity meter (1) by being positioned on a phase to be calibrated (PhC), the method being **characterized in that** it comprises the first steps of:

   - positioning the Rogowski sensor to be calibrated on a first reference phase (PhB), on which a first already-calibrated reference Rogowski sensor (CB) is positioned, or positioning the first reference Rogowski sensor on the phase to be calibrated;
   - acquiring a first calibration current measurement produced by the Rogowski sensor to be calibrated (CC), a first reference current measurement produced by the first reference Rogowski sensor (CB), and a first reference voltage measurement on a first positioning phase (PhB; PhC) on which are positioned the Rogowski sensor to be calibrated and the first reference Rogowski sensor following the positioning step;
   - using the first calibration current measurement, the first reference current measurement and the first reference voltage measurement to produce first calibration parameters ($K_1$, $\Delta\varphi_1$) of the Rogowski sensor to be calibrated.

2. Calibration method according to claim 1, further comprising the steps of calculating a first active calibration power and a first reactive calibration power from the first calibration current measurement and from the first reference voltage measurement, as well as a first reference active power and a first reference reactive power from the first reference current measurement and from the first reference voltage measurement, and of calculating the first calibration parameters from the first active calibration power, from the first reactive calibration power, from the first reference active power and from the first reference reactive power.

3. Calibration method according to one of the preceding claims, in addition comprising second steps similar to the first steps, but implemented with, instead of the first reference phase and of the first reference Rogowski sensor, a second reference phase (PhA) and a second already-calibrated reference Rogowski sensor (CA), the first steps and the second steps making it possible to produce consolidated calibration parameters of the Rogowski sensor to be calibrated (CC).

4. Calibration method according to claim 3, the second steps making it possible to produce second calibration parameters ($K_2$, $\Delta\varphi_2$), the method further comprising the step of calculating an arithmetic average of the first calibration parameters and of the second calibration parameters to produce the consolidated calibration parameters.

5. Calibration method according to claims 2 and 3, wherein the second steps comprise the step of calculating a second reference active power and a second reference reactive power, the method further comprising the steps of calculating an arithmetic average of the first reference active power and of the second reference active power to obtain an averaged reference active power, and of calculating an arithmetic average of the first reference reactive power and of the second reference reactive power to obtain an averaged reference reactive power, the consolidated calibration parameters being obtained from the first active calibration power, from the first reactive calibration power, from the averaged reference active power and from the averaged reference reactive power.

6. Calibration method according to claims 2 and 3, wherein the first steps comprise the step of positioning the first reference Rogowksi sensor (CB) on the phase to be calibrated (PhC), wherein the second steps comprise the step of positioning the second reference Rogowski sensor (CA) on the phase to be calibrated (PhC), and wherein the step of acquiring the first steps and the step of acquiring the second steps are carried out simultaneously.

7. Calibration method according to one of the preceding claims, wherein the calibration parameters comprise a gain and a dephasing of a current measuring chain comprising the Rogowksi sensor to be calibrated (CC) and an internal processing circuit integrated in the meter and comprising an integrator.

8. Multiphase electricity meter comprising a processing unit (4) arranged to implement the calibration method according to one of the preceding claims.

9. Multiphase electricity meter according to claim 8, further comprising a man-machine interface (3), the processing unit (4) being arranged to communicate with an operator via the man-machine interface (3) to cause it to position the Rogowksi sensor to be calibrated (CC) and/or the first reference Rogowski sensor (CB) and/or the second reference Rogowksi sensor (CA) so as to implement the calibration method, and to, when the calibration method has been carried out, reposition the Rogowski sensor to be calibrated and/or the first reference Rogowksi sensor and/or the second reference Rogowksi sensor in their nominal position, so as to return the meter and the Rogowski sensors into a nominal configuration.

10. Computer program comprising instructions which drive the processing unit (4) of the multiphase electricity meter (1) according to one of claims 8 or 9 to execute the steps of the calibration method according to one of claims 1 to 7.

11. Computer-readable recording medium, on which the computer program according to claim 10 is recorded.

EP 4 102 246 B1

Fig. 1

Fig. 2

13

Fig. 3

Fig. 4

Fig. 5

Fig. 6

Début — E0

Entrée mot de passe
(Accès IHM compteur
protégée par mot de passe) — E1

Passage en mode de
calibration — E2

Programmation de la phase
à calibrer (A, B ou C) — E3

E4 — Nombre de phases de référence ?

2 — On sait alors quelles sont les 2 phases de référence

1

Entrée de la phase de référence parmi les 2 restantes (A, B ou C) — E5

E6 — Demande de positionnement du capteur de Rogowski à calibrer sur la phase du capteur de Rogowski de référence et attente de confirmation

E7 — Détermination des paramètres K et $\Delta\phi$ du nouveau capteur de Rogowski (Calibration de la phase à calibrer via la phase de référence (durée 1 minute)) et mémorisation

Demande de positionnement du capteur de Rogowski à calibrer sur la 1ère phase de référence et attente de confirmation — E8

Détermination des paramètres $K_1$ et $\Delta\phi_1$ du capteur de Rogowski à calibrer (Calibration de la phase à calibrer via la 1ère phase de référence (durée 1 minute)) — E9

Demande de positionnement du capteur de Rogowski à calibrer sur la 2ème phase de référence et attente confirmation — E10

E11 — Détermination des paramètres $K_2$ et $\Delta\phi_2$ du capteur de Rogowski à calibrer (Calibration de la phase à calibrer via la 2ème phase de référence (durée 1 minute))

E12 — Calcul de la moyenne arithmétique respectivement de $K_1$ et $K_2$, et de $\Delta\phi_1$ et de $\Delta\phi_2$ et mémorisation

E13 — Demande de remise en place des capteurs de Rogowski selon la Figure 1

E14 — Remise en place effectuée ?

NON

OUI

E15 — Sortie du mode de calibration et retour en mode normal

Fin — E16

Fig. 7

```
                    ╭─────────╮
                    │  Début  ├──── E20
                    ╰────┬────╯
              ┌──────────┴──────────┐
              │  Entrée mot de passe │
              │  (Accès IHM compteur ├──── E21
              │protégée par mot de passe)│
              └──────────┬──────────┘
              ┌──────────┴──────────┐
              │  Passage en mode de  ├──── E22
              │     calibration      │
              └──────────┬──────────┘
              ┌──────────┴──────────┐
              │Programmation de la phase├──── E23
              │  à calibrer (A, B ou C) │
              └──────────┬──────────┘
```

E24

Nombre de capteurs de Rogowski de référence ?

2

On sait alors quelles sont les 2 capteurs de Rogowski de référence

1

E25 — Entrée du capteur de Rogowski de référence parmi les 2 restants (A, B ou C)

E28 — Demande de positionnement des 2 capteur de Rogowski référence sur la phase du capteur de Rogowski à calibrer et attente de confirmation

E26 — Demande de positionnement du capteur de Rogowski référence sur la phase du capteur de Rogowski à calibrer et attente de confirmation

E29 — Détermination des paramètres $K_1$ et $\Delta\phi_1$ du capteur de Rogowski à calibrer. Calibration du capteur de Rogowski à calibrer via le 1er capteur de Rogowski de référence. Détermination des paramètres $K_2$ et $\Delta\phi_2$ du capteur de Rogowski à calibrer. Calibration du capteur de Rogowski à calibrer via le 2ème capteur de Rogowski de référence (durée 1 minute)

E27 — Détermination des paramètres K et $\Delta\phi$ du nouveau capteur de Rogowski (Calibration de la phase à calibrer via la phase de référence (durée 1 minute)) et mémorisation

E30 — Calcul de la moyenne arithmétique respectivement de $K_1$ et $K_2$, et de $\Delta\phi_1$ et de $\Delta\phi_2$ et mémorisation

E31 — Demande de remise en place des capteurs de Rogowski selon la Figure 1

E32

Remise en place effectuée ?

NON

OUI

E33 — Sortie du mode de calibration et retour en mode normal

Fin — E34

## RÉFÉRENCES CITÉES DANS LA DESCRIPTION

**Documents brevets cités dans la description**

- US 2014340072 A
- US 2020033435 A
- US 2008211484 A